(19) Europäisches Patentamt
European Patent Office
Office européen des brevets

(11) EP 4 697 044 A1

(12) **EUROPEAN PATENT APPLICATION**
published in accordance with Art. 153(4) EPC

(43) Date of publication:
**18.02.2026 Bulletin 2026/08**

(21) Application number: 24915450.1

(22) Date of filing: **30.12.2024**

(51) International Patent Classification (IPC):
*G01R 31/392* (2019.01)    *G01R 31/396* (2019.01)
*G01R 31/382* (2019.01)    *G01R 31/367* (2019.01)
*G01R 19/30* (2006.01)    *G01R 19/12* (2006.01)

(52) Cooperative Patent Classification (CPC):
**G01R 19/12; G01R 19/30; G01R 31/367;**
**G01R 31/382; G01R 31/392; G01R 31/396**

(86) International application number:
**PCT/KR2024/021438**

(87) International publication number:
**WO 2025/147038 (10.07.2025 Gazette 2025/28)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **02.01.2024 KR 20240000301**

(71) Applicant: **LG Energy Solution, Ltd.**
**Seoul 07335 (KR)**

(72) Inventors:
• **CHOI, Hyun-Jun**
**Daejeon 34122 (KR)**
• **KIM, Tae-Hyeon**
**Daejeon 34122 (KR)**
• **KIM, Young-Deok**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY DIAGNOSIS APPARATUS, BATTERY PACK, BATTERY SYSTEM AND BATTERY DIAGNOSIS METHOD**

(57)    There are provided a battery diagnosis apparatus, a battery pack, a battery system and a battery diagnosis method. The battery diagnosis apparatus includes a data acquisition unit configured to acquire capacity-voltage relationship data of a battery cell, and a processor configured to generate a voltage profile and a differential voltage profile of the battery cell based on the capacity-voltage relationship data. The processor is configured to extract a first profile of interest from the voltage profile based on a feature point of the differential voltage profile. The processor is configured to determine a characteristic curvature related to the first profile of interest. The processor is configured to diagnose a degradation state of the battery cell based on the characteristic curvature.

FIG. 1

**Description**

TECHNICAL FIELD

The present disclosure relates to diagnosis of degradation in battery cells.

The present application claims priority to Korean Patent Application No. 10-2024-0000301 filed on January 2, 2024 in the Republic of Korea, the disclosure of which is incorporated herein by reference.

BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

There are many different degradation monitoring techniques for battery cells. In particular, Differential Voltage Analysis (DVA) is based on time-series data of at least one battery parameter (for example, voltage, current, capacity) that can be observed outside of battery cells.

In DVA, peaks in a differential voltage curve (also referred to as a 'Q-dV/dQ profile') are considered as key factors, and some types of battery cells have a voltage plateau characteristic that a change in voltage is maintained at almost 0 during charging or discharging. Because differential voltage is also close to 0 in the capacity range in which the voltage plateau characteristic is found, it is difficult to detect a peak from the Q-dV/dQ profile. Accordingly, there is a need for an approach to diagnose degradation in battery cells accurately and easily without extracting peak information indicating degradation from the Q-dV/dQ profile.

DISCLOSURE

Technical Problem

The present disclosure is designed to solve the above-described problem, and therefore the present disclosure is directed to providing a battery diagnosis apparatus and method for precisely estimating at least one degradation parameter for a degradation state of a battery cell without disassembling the battery cell.

These and other objectives and advantages of the present disclosure may be understood from the following description and will become apparent from the exemplary embodiments of the present disclosure. Also, it will be easily understood that the objectives and advantages of the present disclosure may be realized by the means set forth in the appended claims and a combination thereof.

Technical Solution

A battery diagnosis apparatus according to an aspect of the present disclosure includes a data acquisition unit configured to acquire capacity-voltage relationship data of a battery cell, and a processor configured to generate a voltage profile and a differential voltage profile of the battery cell based on the capacity-voltage relationship data. The processor is configured to extract a first profile of interest from the voltage profile based on a feature point of the differential voltage profile. The processor is configured to determine a characteristic curvature related to the first profile of interest. The processor is configured to diagnose a degradation state of the battery cell based on the characteristic curvature.

The processor may be configured to determine a data point having a minimum differential voltage value in a target capacity range as the feature point of the differential voltage profile.

The processor may be configured to determine a capacity range of interest based on a capacity value of the feature point of the differential voltage profile. The processor may be configured to determine a portion of the voltage profile corresponding to the capacity range of interest as the first profile of interest.

The processor may be configured to determine a second profile of interest by normalizing a capacity-voltage domain of the first profile of interest to match it to a reference capacity-voltage domain. The processor may be configured to determine the characteristic curvature based on a plurality of data points of the second profile of interest.

The processor may be configured to determine a plurality of curvatures associated with a plurality of point sets respectively. Each point set may include three data points of the plurality of data points. The processor may be configured to determine the characteristic curvature to be equal to a minimum of the plurality of curvatures or an average of two or more curvatures of the plurality of curvatures.

The processor may be configured to determine the curvature related to each point set to be equal to a curvature of a circle passing through the three data points of the corresponding point set.

The processor may be configured to determine a first degradation parameter indicating a positive electrode degradation derived capacity reduction ratio of the battery cell by using the characteristic curvature as an input variable of a linear regression model.

The processor may be configured to determine a second degradation parameter indicating a loss of available lithium derived capacity reduction ratio of the battery cell based on a total capacity reduction ratio of the battery cell and the first degradation parameter.

The capacity-voltage relationship data may include a capacity time series and a voltage time series of the battery cell during charging or discharging of the battery cell.

A battery pack according to another aspect of the present disclosure includes the battery diagnosis apparatus.

A battery system according to still another aspect of the present disclosure includes the battery diagnosis apparatus.

A battery diagnosis method according to further another aspect of the present disclosure includes the steps of acquiring capacity-voltage relationship data of a battery cell, generating a voltage profile and a differential voltage of the battery cell based on the capacity-voltage relationship data, extracting a first profile of interest from the voltage profile based on a feature point of the differential voltage profile, determining a characteristic curvature related to the first profile of interest, and diagnosing a degradation state of the battery cell based on the characteristic curvature.

The step of extracting the first profile of interest from the voltage profile may include the steps of determining a capacity range of interest based on a capacity value of the feature point of the differential voltage profile, and determining a portion of the voltage profile corresponding to the capacity range of interest as the first profile of interest.

The step of determining the characteristic curvature related to the first profile of interest may include the steps of determining a second profile of interest by normalizing a capacity-voltage domain of the first profile of interest to match it to a reference capacity-voltage domain, and determining the characteristic curvature based on a plurality of data points of the second profile of interest.

The step of determining the characteristic curvature based on the plurality of data points of the second profile of interest may include the steps of determining a plurality of curvatures associated with a plurality of point sets respectively, wherein each point set includes three data points of the plurality of data points, and determining the characteristic curvature to be equal to a minimum of the plurality of curvatures or an average of two or more curvatures of the plurality of curvatures.

Advantageous Effects

According to at least one of the embodiments of the present disclosure, it may be possible to precisely estimate at least one degradation parameter for the degradation state of the battery cell without disassembling the battery cell. In particular, the present disclosure may diagnose the positive electrode degradation state of the battery cell in a nondestructive manner.

Additionally, according to at least one of the embodiments of the present disclosure, it may be possible to determine the positive electrode degradation state (for example, the positive electrode degradation derived capacity degradation ratio) of the battery cell more precisely by extracting and analyzing a part (the 'first profile of interest' as described below) of the voltage profile in which the voltage characteristics of the positive electrode material dominate the voltage characteristics of the negative electrode material in the entire voltage profile (the 'Q-V profile' as described below) of the battery cell in the predetermined voltage range.

Additionally, according to at least one of the embodiments of the present disclosure, it may be possible to easily determine the lithium loss derived capacity reduction ratio from the total capacity reduction ratio and the positive electrode degradation derived capacity reduction ratio of the battery cell by using a relationship between the total capacity reduction ratio, the positive electrode degradation derived capacity reduction ratio and the lithium loss derived capacity reduction ratio of the battery cell.

The effects of the present disclosure are not limited to the aforementioned effects, and these and other effects will be clearly understood by those skilled in the art from the appended claims.

BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be construed as being limited to the drawings.

FIG. 1 is a diagram exemplarily showing a battery system according to the present disclosure.

FIG. 2 is a graph showing an example of a Q-V profile of a battery cell.

FIG. 3 is a graph showing an example of a normalized Q-V profile acquired from the Q-V profile of FIG. 2.

FIG. 4 is a graph showing an example of a Q-dV/dQ profile related to the normalized Q-V profile shown in FIG. 3.

FIG. 5 is a graph showing an example of a first profile of interest.

FIG. 6 is a graph showing an example of a second profile of interest.

FIG. 7 is a diagram referenced in describing a procedure of determining a characteristic curvature of the second profile of interest shown in FIG. 6.

FIG. 8 is a diagram referenced in exemplarily describing a relationship between a positive electrode degradation level and a second profile of interest.

FIGS. 9 to 11 are diagrams referenced in comparing characteristic curvatures of three second profiles of interest shown in FIG. 8.

FIG. 12 is a diagram referenced in exemplarily describing a relationship between a positive electrode degradation level and a characteristic curvature.

FIG. 13 is a flowchart schematically showing a battery diagnosis method according to an embodiment of the present disclosure.

FIG. 14 is a flowchart exemplarily showing the sub-routines that may be included in the step S1330 in FIG. 13.

FIG. 15 is a flowchart exemplarily showing the sub-routines that may be included in the step S1410 in FIG. 14.

FIG. 16 is a flowchart exemplarily showing the sub-routines that may be included in the step S1340 in FIG. 13.

FIG. 17 is a flowchart exemplarily showing the sub-routines that may be included in the step S1620 in FIG. 16.

## BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure and are not intended to be limiting, so it should be understood that a variety of other equivalents and modifications could have been made thereto at the time the application was filed.

The terms including ordinal numbers such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

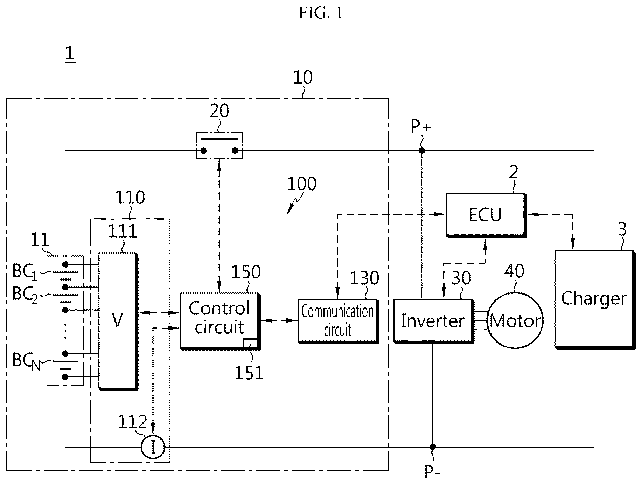

FIG. 1 is a diagram exemplarily showing a battery system according to the present disclosure.

Referring to FIG. 1, the battery system 1 includes a system controller 2, a battery pack 10, an inverter 30 and an electric motor 40. Charge/discharge terminals P+, P- of the battery pack 10 may be electrically coupled to a charger 3 through a charging cable. The charger 3 may be included in the battery system 1, or may be present in a charging station.

The system controller 2 (for example, an Electronic Control Unit (ECU)) is configured to transmit a key-on signal to a battery diagnosis apparatus 100 in response to a user's changing a starter button (not shown) of the battery system 1 to an ON-position. The system controller 2 is configured to transmit a key-off signal to the battery diagnosis apparatus 100 in response to the user's changing the starter button to an OFF-position. The charger 3 may supply a charge power selected from constant power, constant current and constant voltage through the charge/discharge terminals P+, P- of the battery pack 10 via communication with the system controller 2.

The battery pack 10 includes a battery 11 and a relay 20. The battery pack 10 may further include the battery diagnosis apparatus 100.

The battery 11 includes at least one battery cell BC. In FIG. 1, the battery 11 including a plurality of battery cells $BC_1 \sim BC_N$ (N is a natural number of 2 or greater) connected in series is shown by way of illustration. The plurality of battery cells $BC_1 \sim BC_N$ may be provided with the same electrochemical specification. Hereinafter, in describing the common description of the plurality of battery cells $BC_1 \sim BC_N$, the symbol 'BC' is affixed to the battery cell. The charger 3 may perform charge/discharge cycles needed to diagnose the degradation state of the battery cell BC through collaboration with the inverter 30 having a discharge function.

The battery cell BC is to be diagnosed by the battery diagnosis apparatus 100. The battery cell BC is not limited to a particular type and may include any electrochemical device that can be repeatedly charged and discharged. Preferably, the battery cell BC may be a lithium iron phosphate battery cell having voltage plateau characteristic. The voltage plateau characteristic refers to a characteristic that a change in voltage is kept less than a predetermined threshold over at least one capacity range (or State Of Charge (SOC) range). The lithium iron phosphate battery cell may be also referred to as 'LiFePO$_4$ battery cell', 'LFP battery cell' or 'LFP cell'. Hereinafter, assume that the battery cell BC is a LFP battery cell including LFP and graphite as a positive electrode material and a negative electrode material, respectively.

The relay 20 is electrically connected in series to the battery 11 through a power path connecting the battery 11 and the inverter 30. FIG. 1 shows the relay 20 connected between a positive terminal of the battery 11 and the charge/discharge terminal P+. The relay 20 is controlled to turn on/off in response to the switching signal from the battery diagnosis apparatus 100. The relay 20 may be a mechanical contactor that turns on or off by the magnetic force of a coil or a semiconductor switch such as Metal Oxide Semiconductor Field Effect transistor (MOSFET).

The inverter 30 is provided to convert a direct current from the battery 11 included in the battery pack 10 to an alternating current in response to a command from the battery diagnosis apparatus 100 or the system controller 2. The electric motor 40 operates using the alternating current from the inverter 30. The electric motor 40 may include, for example, a 3-phase alternating current motor. The components in the battery system 1 supplied with the discharge power of the battery 11 including the inverter 30 and the electric motor 40 may be referred collective to as an electrical load.

The battery diagnosis apparatus 100 includes a processor 150. The battery diagnosis apparatus 100 may further include at least one of a sensing unit 110 or a communication circuit 130.

The sensing unit 110 includes a voltage sensor 111. The sensing unit may further include a current sensor 112.

The voltage sensor 111 is connected to the positive and negative terminals of the battery cell BC, and is configured to detect a voltage (referred to as 'full cell voltage') across the battery cell BC, and generate a voltage signal indicating a detection value of the detected voltage. The voltage sensor 111 may include one of known voltage detection devices such as a voltage measurement IC or a combination thereof.

The current sensor 112 is connected in series to the battery 11 through the current path between the battery 11 and the inverter 30. The current sensor 112 is configured to detect the current (referred to as 'charge/discharge current') flowing through the battery 11, and generate a current signal indicating a detection value of the detected current. Because the plurality of battery cells $BC_1 \sim BC_N$ is connected in series, the current flowing in the battery 11 is the same as the current flowing in the battery cell BC. The current sensor 112 may include one of known current detection devices such as a shunt resistor or a Hall-effect device or a combination thereof.

The communication circuit 130 is configured to support wired or wireless communication between at least one of the system controller 2, the sensing unit 110 or an external device (not shown) and the processor 150. The wired communication may be, for example, controller area network (CAN) communication, and the wireless communication may be, for example, Zigbee or Bluetooth communication. The communication protocol is not limited to a particular type and may include those that support the wired/wireless communication between the processor 150 and the system controller 2. The communication circuit 130 may include an output device (for example, a display, a speaker) to provide information received from the processor 150 and/or the system controller 2 into a recognizable format for the user.

The term 'data acquisition unit' as used herein may include at least one of the sensing unit 110 or the communication circuit 130.

The processor 150 may be operably coupled to at least one of the relay 20, the sensing unit 110 or the communication circuit 130. Here, "operably coupled" refers to direct/indirect connection to enable signal transmission and reception in one or two directions.

The processor 150 may be also referred to as 'control circuit' and be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The memory 151 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 151 may store data and programs required for the computation operation by the processor 150. The memory 151 may store data indicating the results of the computation operation by the processor 150. The memory 151 may store data sets and software used to diagnose the degradation state of the battery cell BC. The memory 151 may be integrated in the processor 150.

The processor 150 may collect the voltage signal from the sensing unit 110 and the current signal from the current sensor 112. In this specification, the detection signal may refer to the voltage signal alone or both the voltage signal and the current signal. That is, the processor 150 may convert and record each analogue signal collected from the sensing unit 110 into a digital value by using an Analog to Digital Converter (ADC) equipped therein. Alternatively, each of the voltage sensor 111 and the current sensor 112 may include the ADC therein, and transmit the digital value produced by the ADC to the processor 150.

When the relay 20 is turned on during operation of the electrical load 30, 40 and/or the charger 3, the battery 11 is in a charge mode or a discharge mode. When the relay 20 is turned off while the battery 11 is in use in the charge mode or the discharge mode, the battery 11 is changed to a rest mode.

The processor 150 may turn on the relay 20 in response to the key-on signal. The processor 150 may turn off the relay 20 in response to the key-off signal. The key-on signal is a signal that requests a change from rest to charge or discharge. The key-off signal is a signal that requests a change from charge or discharge to rest. Alternatively, instead of the processor 150, the system controller 2 may take responsibility for on-off control of the relay 20.

In this specification, a time series of a parameter indicates a time-dependent change history of the parameter for a certain or specific period of time. Additionally, a profile (or a curve) indicating a correspondence relationship between two parameters acquired at the same timing for the same period of time may be a polynomial equation acquired by mapping time-series data of the two parameters to represent in the form of a 2-dimensional graph, or by applying a predetermined curve fitting logic to a pair of two mapped time-series data. Here, the degree of the highest degree term of the polynomial equation may be preset.

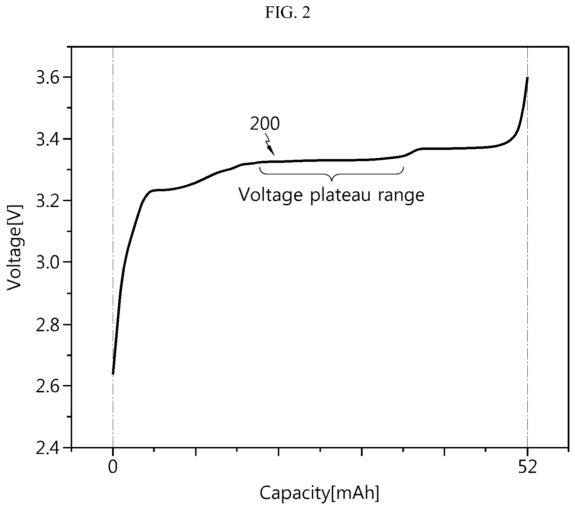

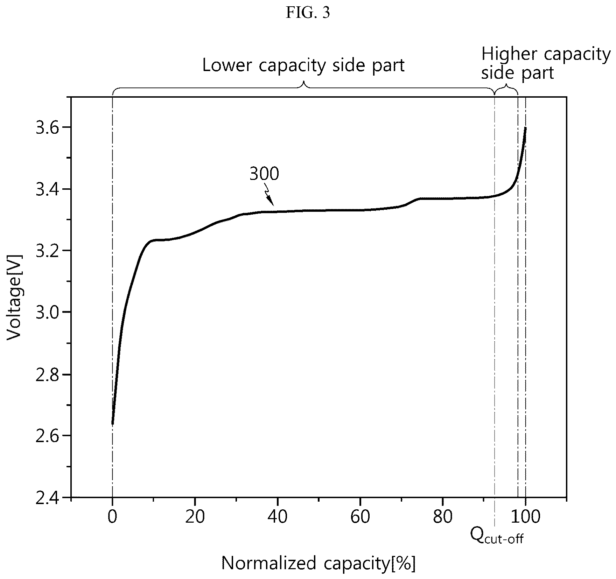

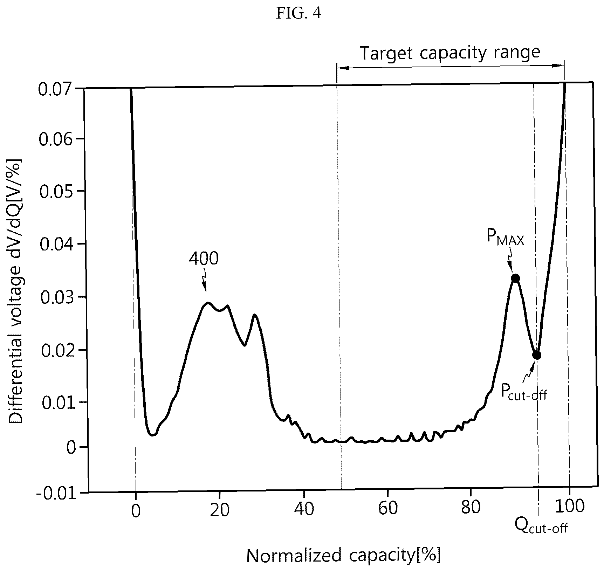

FIG. 2 is a graph showing an example of a Q-V profile of the battery cell, FIG. 3 is a graph showing an example of a normalized Q-V profile acquired from the Q-V profile of FIG. 2, and FIG. 4 is a graph showing an example of a Q-dV/dQ profile related to the normalized Q-V profile shown in FIG. 3.

In the graph shown in FIG. 2, the vertical axis indicates the voltage of the battery cell BC, and the horizontal axis indicates the capacity (unit mAh). The reference numeral 200 indicates the Q-V profile based on capacity-voltage relationship data of the battery cell BC.

The Q-V profile 200 may be also referred to as 'capacity-voltage profile', 'capacity-voltage curve' or 'voltage profile'. As described above, the battery cell BC has the voltage plateau characteristic, and the Q-V profile 200 shows that voltage is almost uniformly maintained over the capacity range between about 20 mAh and 40 mAh.

The Q-V profile 200 may be based on the capacity-voltage relationship data acquired by the data acquisition unit during at least one of charge cycling or discharge cycling of the battery cell BC. In any one of charge cycling or discharge cycling, constant power or constant current may be used. Hereinafter, for convenience of description, assume that the Q-V profile 200 is related to the charge cycle. The following description of the charge cycle may be shared with the discharge cycle in which the discharge current flows through the battery cell BC.

In the constant power charge cycle, as the voltage of the battery cell BC increases, the charge current gradually reduces. Accordingly, not only voltage time-series data indicating time-dependent change history of the voltage of the battery cell BC, but also voltage time-series data indicating time-dependent change history of the current flowing through the battery cell BC is essentially required.

In the constant current charge cycle, the charge current having a predetermined current rate (for example, 0.1C, 0.5C, 1.5C or 2.0C) is controlled to flow through the battery cell BC. Accordingly, it may be assumed that a capacity value at a specific time is equal to a value obtained by multiplying the elapsed time from the start time of the constant current charge cycle to the specific time (i.e., a time difference between the start time and the specific time) by a current value corresponding to the current rate.

Even in the constant current charge cycle, the actual charge current may be temporarily smaller or larger than the intended charge current. By this reason, the processor 150 may generate capacity time-series data by repeatedly performing a procedure of accumulating and recording a current measurement value acquired by periodically measuring the current flowing in the battery cell BC by using the current sensor 112.

The charge cycle may last until the voltage of the battery cell BC changes at least over a predetermined voltage range. The Q-V profile 200 indicates a correspondence relationship between capacity and voltage of the battery cell BC acquired for a period of time until the voltage of the battery cell BC reaches the upper voltage limit of the predetermined voltage range from the lower voltage limit by the charge cycle.

The Q-V profile 200 shown in FIG. 2 shows the voltage of the battery cell BC rises from 2.6V (a predetermined lower voltage limit) to 3.6V (a predetermined upper voltage limit) while the capacity of the battery cell BC changes from 0 mAh to 52 mAh. Here, the range between 0 mAh and 52 mAh may be the entire capacity range of the Q-V profile 200, and this corresponds to the predetermined voltage range.

In relation, the entire capacity range corresponding to the predetermined voltage range may change (non-fixed) depending on the degradation state of the battery cell BC. Additionally, even though the degradation state of two different battery cells is the same, the capacity range of the two battery cells BC may be different due to the process deviation in the manufacture. To improve the ease and adequacy of data processing required to diagnose the degradation state of the battery cell BC, and ensure the accuracy of the diagnosis result, it is necessary to normalize the Q-V profile 200 by applying a normalization procedure over the entire capacity range of the Q-V profile 200.

In the graph shown in FIG. 3, the vertical axis indicates the voltage of the battery cell BC in the same way as FIG. 2, and the horizontal axis indicates normalized capacity (unit %). The normalized capacity may be the term of the equivalent concept to SOC. The reference numeral 300 is an example of another Q-V profile as a result of applying a normalization procedure to the Q-V profile 200.

When it is assumed that the capacity-voltage relationship according to the Q-V profile 200 has a mathematical relationship according to the following Equation 1, the normalized voltage and capacity according to the Q-V profile 300 may have a mathematical relationship according to the following Equation 2. The Q-V profile 300 may be used as the 'voltage profile' as claimed.

$$<\text{Equation 1}>$$

$$V_B = f_1(Q_B)$$

$$<\text{Equation 2}>$$

$$V_B = f_2(Q_{B\_normal}) = f_2\left(\frac{Q_B}{Q_{total}} \times 100\right) = f_1\left(\frac{Q_{total} \times Q_{B\_normal}}{100}\right)$$

In Equation 1, $Q_B$ denotes an arbitrary capacity value within the entire capacity range, and $V_B$ denotes a voltage value of a data point corresponding to $Q_B$ in the Q-V profile 200. In Equation 2, $Q_{B\_normal}$ denotes a normalized capacity value corresponding to $Q_B$, and $Q_{total}$ denotes the size of the entire capacity range (i.e., the upper capacity limit of the entire capacity range).

For reference, FIG. 3 shows the normalized result of each data point of the entire capacity range of FIG. 2 in percentage (a range between 0% and 100%), but this should be understood as an example. For example, the range between 0% and 100% may be replaced with a range between 0 and 1.

Referring to the graph shown in FIG. 4, the reference numeral 400 is an example of Q-dV/dQ profile. The Q-dV/dQ profile 400 may be also referred to as 'capacity-differential voltage profile', 'capacity-differential voltage curve' or 'differential voltage profile'.

The processor 150 may generate the Q-dV/dQ profile 400 by differentiating the voltage of the Q-V profile 300 with respect to the capacity. Specifically, the processor 150 may determine a differential voltage dV/dQ or a ratio of a change dV in the voltage V to a change dQ in the normalized capacity Q[%] based on the Q-V profile 300, and determine the Q-dV/dQ profile 400 as relationship data indicating a correspondence relationship between the normalized capacity Q[%] and the differential voltage dV/dQ. The Q-dV/dQ profile 400 may be recorded in the memory 151.

The processor 150 may determine a feature point from the Q-dV/dQ profile 400. The feature point of the Q-dV/dQ profile 400 may be a data point on the Q-dV/dQ profile 400 located in a predetermined target capacity range. In FIG. 4, the target capacity range between 50% and 99% is shown. The target capacity range may partially overlap the capacity range in which the voltage plateau characteristic of the battery cell BC is found.

For example, the processor 150 may identify a maximum point $P_{MAX}$ having the maximum differential voltage value in the target capacity range from the Q-dV/dQ profile 400. Subsequently, the processor 150 may determine a data point located at the higher capacity side than the maximum point $P_{MAX}$ as a feature point $P_{cut-off}$ from the Q-dV/dQ profile 400. The feature point of the Q-dV/dQ profile 400 may be referred to as a 'cut-off reference point'.

When there are two or more minimum points in the target capacity range, any one minimum point having the largest capacity value $Q_{cut-off}$ among the two or more minimum points may be set as the feature point $P_{cut-off}$.

The feature point $P_{cut-off}$ may be the last minimum point in the Q-dV/dQ profile 400 resulting from the voltage characteristics of the negative electrode material of the battery cell BC. That is, the higher capacity side than the feature point $P_{cut-off}$ may be the capacity range in which the voltage characteristics of the positive electrode material of the battery cell BC dominate the voltage characteristics of the negative electrode material. Accordingly, those skilled in the art will easily understand that a degradation parameter caused by the positive electrode degradation of the battery cell BC can be precisely estimated by analyzing the higher capacity side part of the Q-V profile 300.

The inventors confirmed, through many experiments, the fact that the voltage characteristics of the negative electrode material are reflected in the higher capacity side part than the feature point $P_{cut-off}$ to a relatively very small extent compared to the other part of the Q-V profile 300. Accordingly, the inventors recognized that among many different degradation parameters related to the degradation state of the battery cell BC, a parameter for positive electrode degradation may be accurately diagnosed through analysis of the higher capacity side part of the Q-V profile 300.

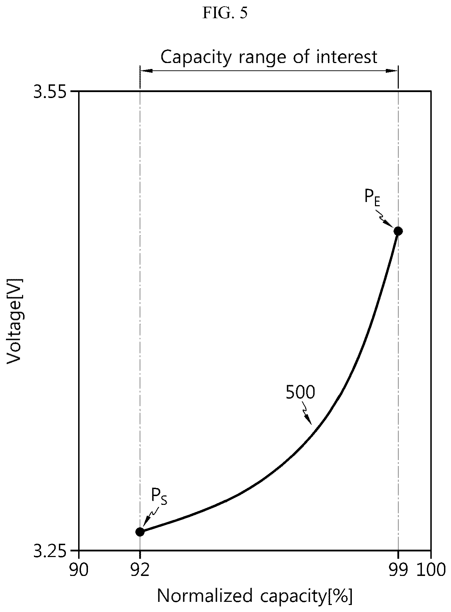

In this specification, when the Q-V profile 300 is divided into a lower capacity side part and a higher capacity side part on the basis of the capacity value $Q_{cut-off}$ of the feature point $P_{cut-off}$ as shown in FIG. 3, the higher capacity side part may be referred to as a 'first profile of interest' (see 500 in FIG. 5).

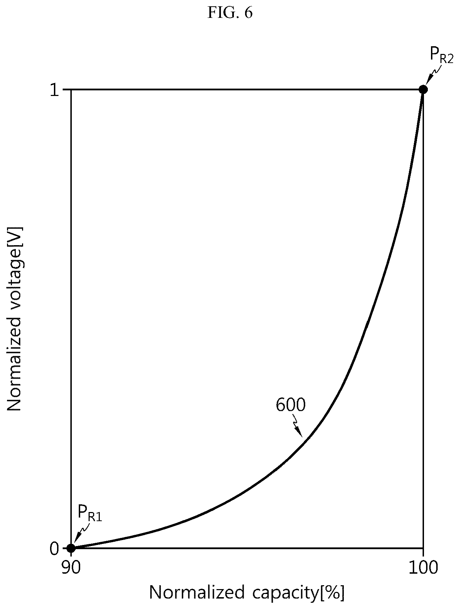

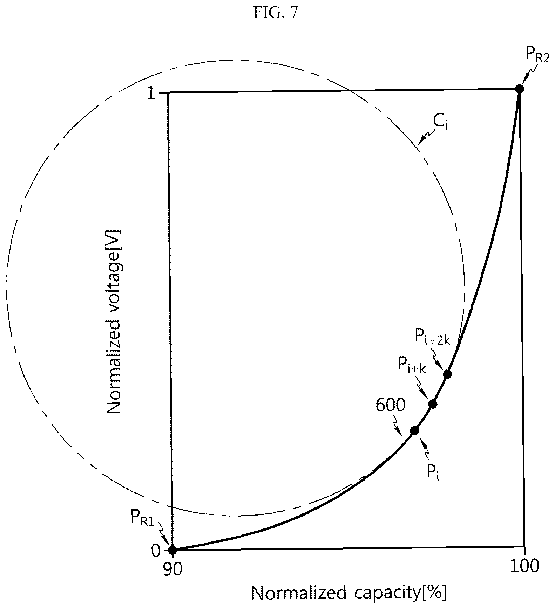

FIG. 5 is a graph showing an example of the first profile of interest, FIG. 6 is a graph showing an example of a second profile of interest, and FIG. 7 is a diagram referenced in describing a procedure of determining a characteristic curvature of the second profile of interest shown in FIG. 6.

Referring to FIG. 5, the first profile of interest 500 is an enlarged form of a portion of the Q-V profile 300 corresponding to a capacity range of interest (for example, 92% to 99%) using the capacity value (for example, 92%) of the feature point $P_{cut-off}$ and the upper capacity limit (for example, 99%) of the target capacity range as the lower limit and the upper limit, respectively.

In relation, when the positive electrode degradation state of the battery cell BC is the same, but other degradation factor such as the negative electrode degradation state or available lithium amount of the battery cell BC is different, the start point, end point and/or shape (for example, curvature) of the first profile of interest 500 may change. Accordingly, similarly to the normalization procedure applied to the Q-V profile 200, it is necessary to apply a normalization procedure to the first profile of interest 500.

Referring to FIG. 6, the second profile of interest 600 as a result of applying the normalization procedure to the first profile of interest 500 is shown.

The processor 150 may determine the second profile of interest 600 by normalizing a capacity-voltage domain of the first profile of interest 500 to match it to a predetermined reference capacity-voltage domain. The reference capacity-voltage domain may be a rectangular area defined by a reference capacity range and a reference voltage range.

Specifically, the processor 150 may generate the second profile of interest 600 by applying the normalization procedure to the first profile of interest 500 to match the start point $P_S$ and the end point $P_E$ of the first profile of interest 500 to a predetermined first reference point $P_{R1}$ and a predetermined second reference point $P_{R2}$, respectively. The reference capacity range may be a capacity range between the first reference point $P_{R1}$ and the second reference point $P_{R2}$, and the reference voltage range may be a voltage range between the first reference point $P_{R1}$ and the second reference point $P_{R2}$.

The start point $P_S$ of the first profile of interest 500 may be a data point having the minimum capacity value of the first profile of interest 500. The end point $P_E$ of the first profile of interest 500 may be a data point having the maximum capacity value of the first profile of interest 500.

The capacity value of the first reference point $P_{R1}$ may be smaller than the capacity value of the start point $P_S$, and the voltage value of the first reference point $P_{R1}$ may be smaller than the voltage value of the start point $P_S$. Additionally, the capacity value of the second reference point $P_{R2}$ may be larger than the capacity value of the end point $P_E$, and the voltage value of the second reference point $P_{R2}$ may be larger than the voltage value of the end point $P_E$.

The processor 150 may perform a first operation of shifting the first profile of interest 500 along the horizontal axis (capacity axis) and the vertical axis (voltage axis) and a second operation of scaling the first profile of interest 500 along the capacity axis and the voltage axis to match the start point $P_S$ to the first reference point $P_{R1}$ or the end point $P_E$ to the second reference point $P_{R2}$. The first operation may include at least one of horizontal movement (leftward or rightward movement with respect to the horizontal axis) or vertical movement (upward or downward movement with respect to the vertical axis). The second operation may include at least one of reduction or enlargement of at least one of the horizontal axis or the vertical axis.

Assume that the 2-dimensional coordinates of the start point $P_S$, the end point $P_E$, the first reference point $P_{R1}$ and the second reference point $P_{R2}$ are $(Q_S, V_S)$, $(Q_E, V_E)$, $(Q_{R1}, V_{R1})$, $(Q_{R2}, V_{R2})$, respectively. In FIG. 6, the 2-dimensional coordinates $(Q_{R1}, V_{R1})$ of the first reference point $P_{R1}$ are (90%, 0V), and the 2-dimensional coordinates $(Q_{R2}, V_{R2})$ of the second reference point $P_{R2}$ are (100%, 1V).

The processor 150 may shift the first profile of interest 500 to the lower capacity side by $Q_S - Q_{R1}$ and to the lower voltage side by $V_S - V_{R1}$. Accordingly, the start point $P_S$ matches the first reference point $P_{R1}$, and in this instance, it is necessary to match the end point $P_E$ to the second reference point $P_{R2}$. Accordingly, the processor 150 may scale the first profile of interest 500 at a ratio of $(Q_{R2} - Q_{R1})/(Q_E - Q_S)$ along the capacity axis and at a ratio of $(V_{R2} - V_{R1})/(V_E - V_S)$ along the voltage axis. Accordingly, the end point $P_E$ matches the second reference point $P_{R2}$, and accordingly the normalization procedure of determining the second profile of interest 600 from the first profile of interest 500 is completed. That is, the second profile of interest 600 may be the result of projection of the first profile of interest 500 onto the reference capacity-voltage domain.

When the capacity and voltage according to the first profile of interest 500 have a mathematical relationship according to Equation 3 below, the capacity and voltage according to the second profile of interest 600 have a mathematical relationship according to Equation 4 below.

<Equation 3>

$$V_B = f_3(Q_{B\_normal})$$

<Equation 4>

$$V_{B\_normal} = f_4(Q_{B\_normal\_2}) = f_4\left(\frac{Q_{total\_normal\_2}}{Q_{total\_normal}} \times (Q_{B\_normal} - Q_S) + Q_{R1}\right)$$

$$= f_3(Q_{B\_normal}) \times \frac{V_{R2} - V_{R1}}{V_E - V_S}$$

$$V_{B\_normal} = f_4(Q_{B\_normal\_2}) = f_4\left(\frac{Q_{R2} - Q_{R1}}{Q_E - Q_S} \times (Q_{B\_normal} - Q_S) + Q_{R1}\right)$$

$$= f_3(Q_{B\_normal}) \times \frac{V_{R2} - V_{R1}}{V_E - V_S}$$

In Equation 3, $Q_{B\_normal}$ denotes the capacity value of an arbitrary data point in the first profile of interest 500, and $V_B$ denotes the voltage value mapped to $Q_{B\_normal}$ in the first profile of interest 500.

In Equation 4, $Q_{B\_normal\_2}$ denotes the capacity value of the second profile of interest 600 corresponding to $Q_{B\_normal}$. For reference, FIG. 6 shows the normalized result of each data point of the entire voltage range of FIG. 5 in the range between 0V and 1V, but it should be understood that this is provided as an example.

The processor 150 may determine the characteristic curvature of the second profile of interest 600. Because the second profile of interest 600 is based on the first profile of interest 500, it may be said that the characteristic curvature is related to the first profile of interest 500.

The second profile of interest 600 may be a collection of data points indicating each of the normalized capacity and the normalized voltage.

Hereinafter, assume that the second profile of interest 600 includes first to n-th data points. Here, n is a natural number of 3 or greater. A capacity difference of two adjacent data points of the first to n-th data points may be a predetermined constant value. Alternatively, a voltage difference of two adjacent data points of the first to n-th data points may be a predetermined constant value.

The first data point may be equal to the first reference point $P_{R1}$, and the n-th data point may be equal to the second reference point $P_{R2}$. Alternatively, the first data point may have a capacity value that is larger than the capacity value of the first reference point $P_{R1}$ by a predetermined value, and the n-th data point may have a capacity value that is smaller than the capacity value of the second reference point $P_{R2}$ by a predetermined value. Alternatively, the first data point may have a voltage value that is larger than the voltage value of the first reference point $P_{R1}$ by a predetermined value, and the n-th data point may have a voltage value that is smaller than the voltage value of the second reference point $P_{R2}$ by a predetermined value.

The first to n-th data points may be a plurality of data points of the second profile of interest 600 arranged in an ascending order on the capacity value basis. An interval (capacity difference) between two adjacent data points of the first to n-th data points may be regular.

The processor 150 may determine first to n-th curvatures associated with the first to n-th data points, respectively. In this specification, assume that the symbol i is a natural number of n or smaller, and k is a preset natural number of 1 or greater.

The procedures for determining the plurality of curvatures based on the first to n-th data points will be described below.

The processor 150 may generate a plurality of point sets from the first to n-th data points. Each point set may include any three data points of the first to n-th data points. The three data points of each point set may be arranged at a regular interval.

When k is a natural number of 1 or greater, indicating the interval between two adjacent data points in a random point set, the number of point sets that can be generated from the first to n-th data points may be n-2k.

FIG. 7 shows three data points $P_i$, $P_{i+k}$, $P_{i+2k}$ included in an i-th point set. For example, where i=30, k=2, a curvature related to data points $P_{32}$, $P_{34}$, $P_{36}$ is determined. The processor 150 may determine the curvature related to the i-th point set to be equal to a curvature of a circle $C_i$ passing through the data points $P_i$, $P_{i+k}$, $P_{i+2k}$. The curvature for each point set may be recorded in the memory 151.

When the above-described procedures are performed for each of the plurality of point sets, a plurality of curvatures is determined. For reference, because the number of point sets is n-2k, the number of curvatures may be also n-2k. The processor 150 may determine the minimum of the plurality of curvatures or the average of two or more curvatures of the plurality of curvatures as the characteristic curvature of the second profile of interest 600.

The control circuit 130 may determine a first degradation parameter by using the characteristic curvature of the second profile of interest 600 to a linear regression model as an input variable. The first degradation parameter may indicate a capacity reduction ratio caused by positive electrode degradation of the battery cell.

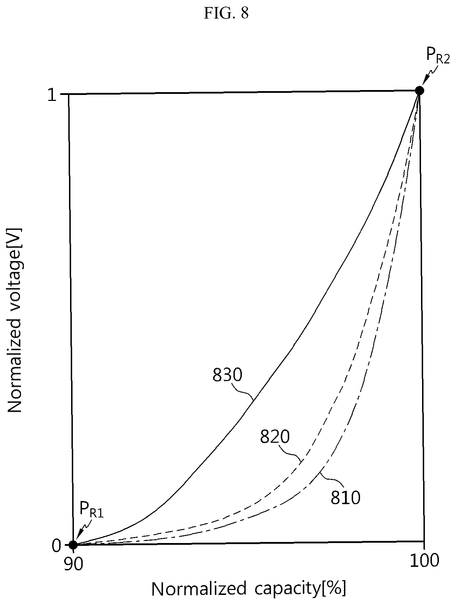

The capacity reduction ratio caused by positive electrode degradation may be referred to as 'positive electrode degradation level' or 'positive electrode degradation derived capacity reduction ratio'. Hereinafter, the linear regression model will be described in more detail with reference to FIGS. 8 to 12.

The inventors created relationship data that is usable for the generation of a linear regression model by performing a first process of forcedly degrading a plurality of battery cells prepared for an experiment to different positive electrode degradation levels, a second process of determining a characteristic curvature related to each of the forcedly degraded battery cell, a third process of dissembling each of the forcedly degraded battery cells to fabricate a positive electrode half cell and a fourth process of measuring and recording the usable capacity (for example, maximum capacity) of each positive electrode half cell in that order.

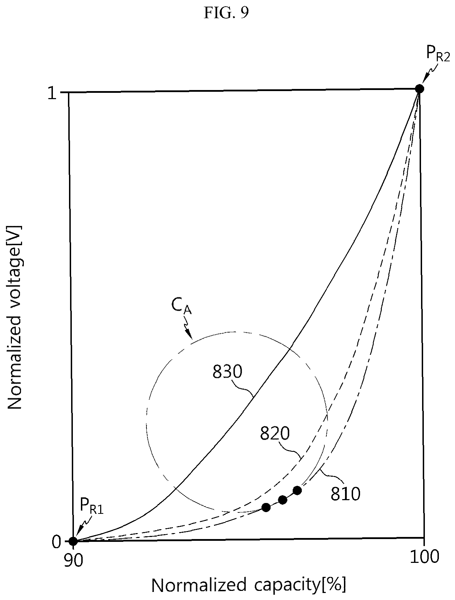

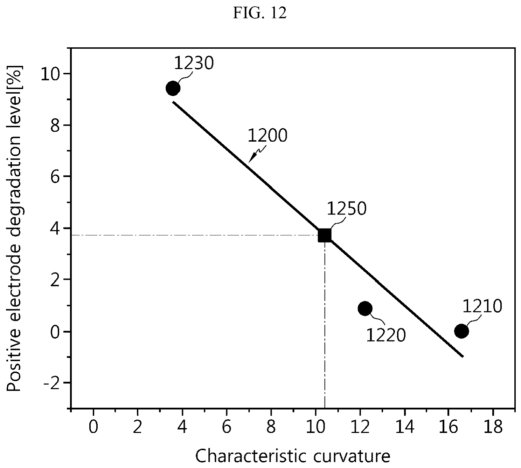

FIG. 8 is a diagram referenced in exemplarily describing a relationship between the positive electrode degradation level and the second profile of interest, FIGS. 9 to 11 are diagrams referenced in comparing characteristic curvatures of three second profiles of interest shown in FIG. 8, and FIG. 12 is a diagram referenced in exemplarily describing a relationship between the positive electrode degradation level and the characteristic curvature.

FIG. 8 exemplarily shows a pattern in which the second profile of interest changes with the increasing positive electrode degradation level. The positive electrode degradation level may refer to a positive electrode degradation derived capacity reduction ratio.

Referring to FIG. 8, a curve 810 indicates the second profile of interest at an initial state before the positive electrode is degraded, i.e., when the positive electrode is fresh, a curve 820 indicates the second profile of interest when the positive electrode degradation level is 1.75%, and a curve 830 indicates the second profile of interest when the positive electrode degradation level is 9.40%.

That is, as the positive electrode degradation level is higher, the second profile of interest gradually changes close to a shape of a straight line connecting the first reference point $P_{R1}$ to the second reference point $P_{R2}$, and accordingly the characteristic curvature of the second profile of interest tends to reduce.

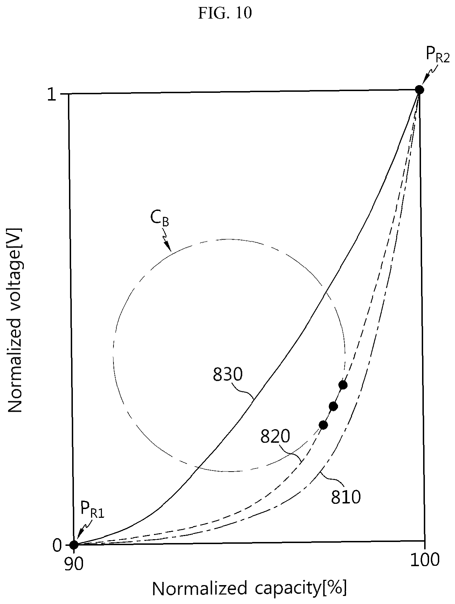

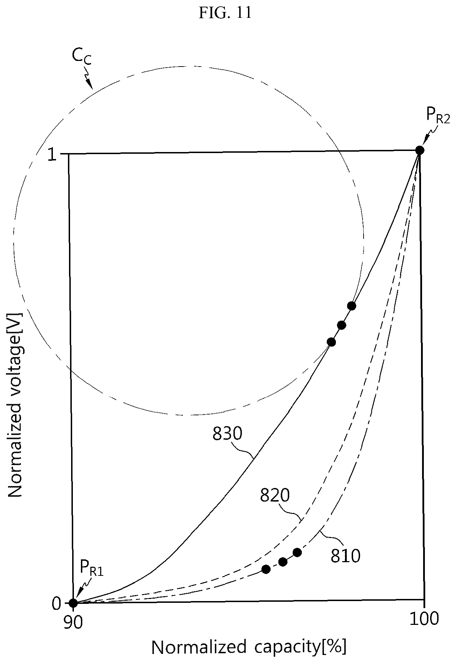

The characteristic curvature of the curve 810 shown in FIG. 9 is a curvature of a circle $C_A$, the characteristic curvature of the curve 820 shown in FIG. 10 is a curvature of a circle $C_B$, and the characteristic curvature of the curve 830 shown in FIG. 11 is a curvature of a circle Cc.

The circle shown in FIG. 10 has a larger diameter than the circle shown in FIG. 9, and the circle shown in FIG. 11 has a larger diameter than the circle shown in FIG. 10. From the inverse proportion between diameter and curvature of a circle, the above-described relation between the positive electrode degradation level and the characteristic curvature is re-confirmed.

Referring to FIG. 12, a linear regression model 1200 may be prepared beforehand as relationship data indicating a correspondence relationship between the characteristic curvature and the positive electrode degradation state. In the graph of FIG. 12, a data point 1210 is related to the curve 810 of FIG. 8, a data point 1220 is related to the curve 820 of FIG. 8, and a data point 1230 is related to the curve 830 of FIG. 8. Although not fully shown, in addition to the data points 1210, 1220, 1230, the inventors have acquired additional data points as the experimental result and used to acquire the linear regression model 1200 through linear regression analysis. The linear regression model 1200 may be pre-stored in the memory 151. Equation 5 below is an example of the linear regression model 1200.

<Equation 5>

$$y = Ax + B$$

In Equation 5, A and B are two coefficients indicating the slope of the straight line and the y axis intercept according to the linear regression model 1200, respectively. x denotes the characteristic curvature (see FIG. 7) as the input variable, and y denotes the positive electrode degradation level as the output variable. A and B may change depending on the type and composition ratio of each of the positive electrode material and the negative electrode material. Accordingly, A and B may be properly tuned according to the type and manufacturing information (for example, the type and composition ratio of each of the positive electrode material and the negative electrode material) of the battery cell BC provided for diagnosis. For example, A and B of the linear regression model 1200 shown in FIG. 12 are -0.759 and 11.64, respectively.

The processor 150 may input the characteristic curvature determined based on the capacity-voltage relationship data of the battery cell BC having an unknown positive electrode degradation state to the linear regression model 1200 as the input variable x, and acquire the positive electrode degradation level as the output variable y. For example, when the characteristic curvature of the battery cell BC is determined to be 10.44, the positive electrode degradation level of the battery cell BC may be determined to be about 3.72% by the linear regression model 1200. In FIG. 12, the reference numeral 1250 indicates a data point corresponding to the characteristic curvature = 10.44 and the positive electrode degradation level = 3.72%.

TABLE 1 below summarizes a relationship between the number of charge cycles (cycle number), the total capacity reduction ratio, the characteristic curvature, the first degradation parameter (positive electrode degradation derived capacity reduction ratio) and the second degradation parameter (loss of available lithium derived capacity reduction ratio). The loss of available lithium may be also referred to as Loss of Lithium Inventory (LLI).

The three rows in TABLE 1 correspond to three data points 1210, 1220, 1230 shown in FIG. 12, respectively. Here, available lithium may refer to lithium ions that may participate in the charge/discharge reaction of the battery cell BC.

<TABLE 1>

| Classification | Total capacity reduction ratio (%) | Characteristic curvature | Positive electrode degradation derived capacity reduction ratio (%) | Loss of available lithium derived capacity reduction ratio (%) |
|---|---|---|---|---|
| Cycle number=0 | 0 | 16.61 | 0 | 0 |
| Cycle number=200 | 6.70 | 12.12 | 0.96 | 5.74 |
| Cycle number=600 | 16.50 | 3.60 | 9.40 | 7.10 |

According to TABLE 1, it can be seen that as the cycle number increases, the characteristic curvature decreases, while each of the total capacity reduction ratio, the first degradation parameter and the second degradation parameter increases. For reference, the cycle number may count up by one each time one charge or discharge cycle is completed.

The total capacity reduction ratio may be a ratio of degradation-induced reduction of full charge capacity to design capacity of the battery cell BC (for example, full charge capacity at beginning of life (BoL)). When it is assumed that design capacity = P, the current full charge capacity = U, the reduction of full charge capacity = W, W = P-U, the total capacity reduction ratio = (W/P) × 100%.

The inventors recognized the fact that the sum of the first degradation parameter and the second degradation parameter substantially equals the total capacity reduction ratio. Accordingly, the processor 150 may determine the second degradation parameter indicating the loss of available lithium derived capacity reduction ratio as the second degradation parameter by subtracting the capacity reduction ratio indicated by the first degradation parameter from the total capacity reduction ratio.

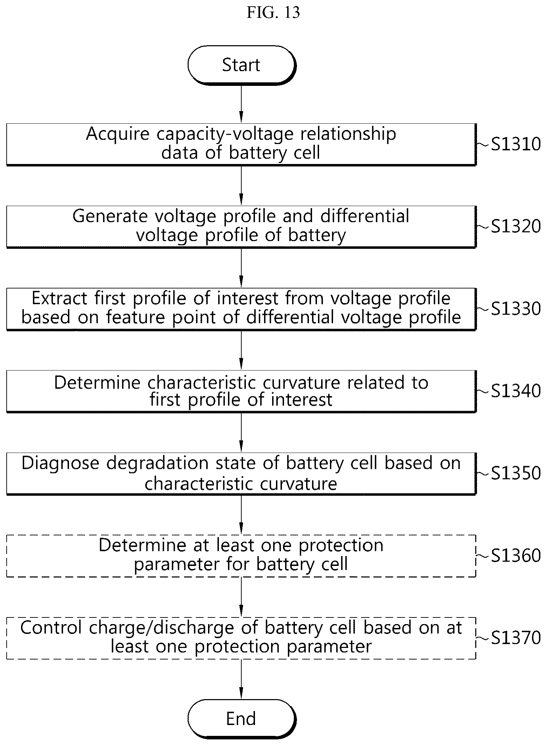

FIG. 13 is a flowchart schematically showing a battery diagnosis method according to an embodiment of the present disclosure. The method according to FIG. 13 includes steps S1310 to S1360. The method according to FIG. 13 may further include step S1370.

Referring to FIGS. 1 to 13, in the step S1310, the data acquisition unit acquires the capacity-voltage relationship data of the battery cell BC. In this specification, acquisition of data or information may refer to generation through software processing, input through a user or an input device and/or reception through a communication channel.

As an example, when the data acquisition unit includes the sensing unit 110, the data acquisition unit may generate the voltage time series and the capacity time series based on the detection signal generated by the sensing unit 110. The capacity-voltage relationship data may include the voltage time series and the capacity time series.

As another example, when the data acquisition unit includes the communication circuit 130, the data acquisition unit may receive the capacity-voltage relationship data from the external device by using the communication circuit 130.

In the step S1320, the processor 150 generates the voltage profile 300 and the differential voltage profile 400 of the battery cell BC based on the capacity-voltage relationship data acquired in the step S1310.

In the step S1330, the processor 150 extracts the first profile of interest 500 from the voltage profile 300 based on the feature point $Q_{cut-off}$ of the differential voltage profile 400.

In the step S1340, the processor 150 determines the characteristic curvature of the first profile of interest 500.

In the step S1350, the degradation state of the battery cell BC is diagnosed based on the characteristic curvature of the first profile of interest 500. In the step S1350, the processor 150 may determine the first degradation parameter y related to the degradation state of the battery cell BC by using the characteristic curvature determined in the step S1340 as the input variable x of the linear regression model 1200 (see Equation 5). The linear regression model 1200 may be prepared beforehand as the relationship data indicating the correspondence relationship between the characteristic curvature and the positive electrode degradation state of the battery cell BC. Accordingly, the first degradation parameter may be determined, and the second degradation parameter may be additionally determined.

In the step S1360, the processor 150 may determine at least one protection parameter for the battery cell BC based on the result of the diagnosis done in the step S1350. For example, at least one of maximum charge voltage, minimum discharge voltage, maximum allowable current or maximum allowable power may be determined as the protection parameter.

In the step S1370, the processor 150 controls the charge/discharge of the battery cell based on the at least one protection parameter. For example, when (i) the voltage of the battery cell BC is equal to or more than the maximum charge voltage or is equal to or less than the minimum discharge voltage, (ii) the current flowing through the battery cell BC is equal to or more than the maximum allowable current, and/or (iii) the charge or discharge power of the battery cell BC is equal to or more than the maximum allowable power, the processor 150 may change the relay 20 to an OFF state, or transmit an operation stop request to the inverter 30 and/or the charger 3.

In the method of FIG. 13, at least one of the step S1360 or the step S1370 may be omitted.

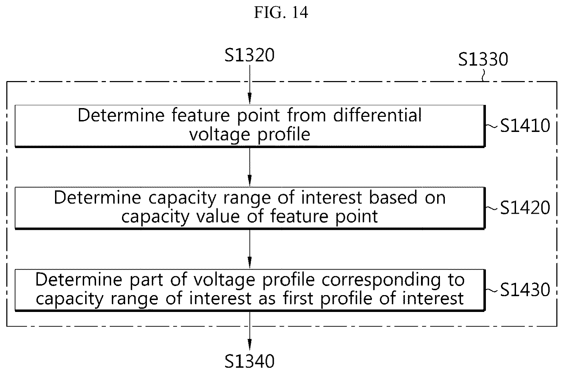

FIG. 14 is a flowchart exemplarily showing the sub-routines that may be included in the step S1330 in FIG. 13.

Referring to FIG. 14, in step S1410, the processor 150 determines the feature point $P_{cut-off}$ from the differential voltage profile 400.

In step S1420, the processor 150 determines the capacity range of interest $P_S \sim P_E$ based on the capacity value $Q_{cut-off}$ of the feature point $P_{cut-off}$.

In step S1430, the processor 150 determines a portion of the voltage profile 300 corresponding to the capacity range of interest $P_S \sim P_E$ as the first profile of interest 500. The first profile of interest 500 may be a higher capacity side part of the voltage profile 300 on the basis of the capacity value $Q_{cut-off}$ of the feature point $P_{cut-off}$.

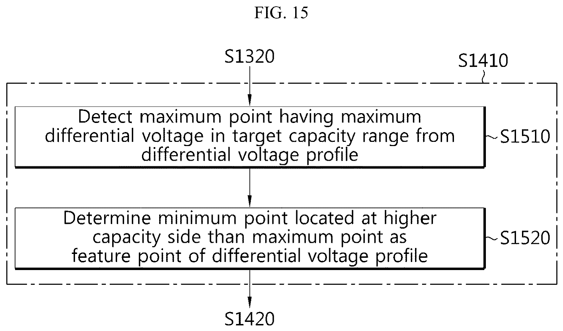

FIG. 15 is a flowchart exemplarily showing the sub-routines that may be included in the step S1410 in FIG. 14.

Referring to FIG. 15, in step S1510, the processor 150 detects the maximum point $P_{MAX}$ having the maximum differential voltage in the target capacity range from the differential voltage profile 400.

In step S1520, the processor 150 determines the minimum point located at the higher capacity side than the maximum point $P_{MAX}$ as the feature point $P_{cut-off}$ of the differential voltage profile from the differential voltage profile 400.

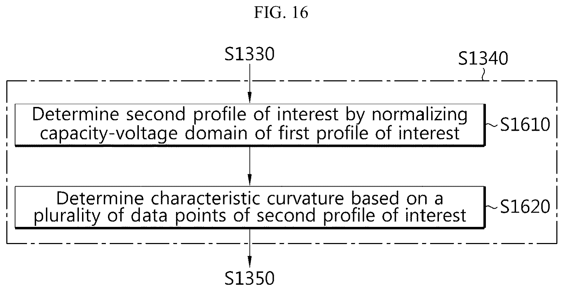

FIG. 16 is a flowchart exemplarily showing the sub-routines that may be included in the step S1330 in FIG. 13.

Referring to FIG. 16, in step S1610, the processor 150 determines the second profile of interest 600 by normalizing the capacity-voltage domain of the first profile of interest 500. The second profile of interest 600 may be the result of performing the shifting operation and the scaling operation on the first profile of interest 500 to match the start point $P_S$ and the end point $P_E$ of the first profile of interest 500 to the predetermined first reference point $P_{R1}$ and the predetermined second reference point $P_{R2}$, respectively.

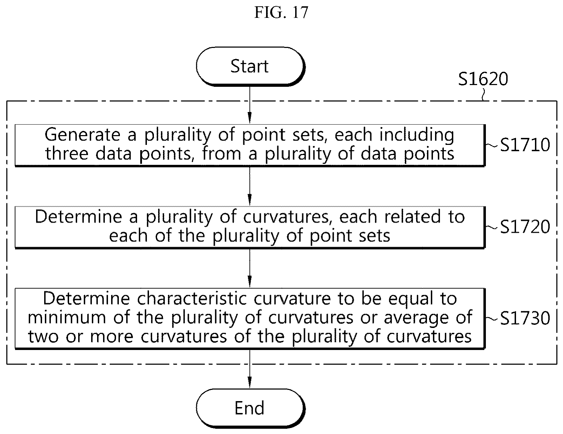

In step S1620, the processor 150 determines the characteristic curvature based on the plurality of data points of the second profile of interest 600. The procedure of the step S1620 will be described in detail with reference to FIG. 17 below.

FIG. 17 is a flowchart exemplarily showing the sub-routines that may be included in the step S1620 in FIG. 16.

Referring to FIG. 17, in step S1710, the processor 150 generates a plurality of point sets, each including three data points from the plurality of data points of the second profile of interest 600. The data points $P_i$, $P_{i+k}$, $P_{i+2k}$ shown in FIG. 7 are included in the i-th point set.

In step S1720, the processor 150 may determine the plurality of curvatures, each related to each of the plurality of point sets. The curvature related to a certain point set may be equal to the curvature of a circle (see the symbol $C_i$ in FIG. 7) passing through the three data points included in the point set. In this instance, because the number of point sets is n-2k, and k is a preset value, n may be a natural number of 2k+2 or greater.

In step S1730, the processor 150 may determine the characteristic curvature to be equal to the minimum of the plurality of curvatures or the average of two or more curvatures of the plurality of curvatures.

The embodiments of the present disclosure as described above are not embodied only through an apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A battery diagnosis apparatus comprising:

   a data acquisition unit configured to acquire capacity-voltage relationship data of a battery cell; and
   a processor configured to generate a voltage profile and a differential voltage profile of the battery cell based on the capacity-voltage relationship data,
   wherein the processor is configured to:

   extract a first profile of interest from the voltage profile based on a feature point of the differential voltage profile,
   determine a characteristic curvature related to the first profile of interest, and
   diagnose a degradation state of the battery cell based on the characteristic curvature.

2. The battery diagnosis apparatus according to claim 1,
   wherein the processor is configured to:
   determine a data point having a minimum differential voltage value in a target capacity range as the feature point of the differential voltage profile.

3. The battery diagnosis apparatus according to claim 1,
   wherein the processor is configured to:

   determine a capacity range of interest based on a capacity value of the feature point of the differential voltage profile, and
   determine a portion of the voltage profile corresponding to the capacity range of interest as the first profile of interest.

4. The battery diagnosis apparatus according to claim 1,
   wherein the processor is configured to:

   determine a second profile of interest by normalizing a capacity-voltage domain of the first profile of interest to match to a reference capacity-voltage domain, and
   determine the characteristic curvature based on a plurality of data points of the second profile of interest.

5. The battery diagnosis apparatus according to claim 4,
   wherein the processor is configured to:

   determine a plurality of curvatures associated with a plurality of point sets respectively, wherein each point set includes three data points of the plurality of data points, and
   determine the characteristic curvature to be equal to a minimum of the plurality of curvatures or an average of two or more curvatures of the plurality of curvatures.

6. The battery diagnosis apparatus according to claim 5,
   wherein the processor is configured to:
   determine the curvature related to each point set to be equal to a curvature of a circle passing through the three data points of the corresponding point set.

7. The battery diagnosis apparatus according to claim 1,
   wherein the processor is configured to:
   determine a first degradation parameter indicating a positive electrode degradation derived capacity reduction ratio of the battery cell by using the characteristic curvature as an input variable of a linear regression model.

8. The battery diagnosis apparatus according to claim 7,
   wherein the processor is configured to:
   determine a second degradation parameter indicating a loss of available lithium derived capacity reduction ratio of the battery cell based on a total capacity reduction ratio of the battery cell and the first degradation parameter.

9. The battery diagnosis apparatus according to claim 1,
   wherein the capacity-voltage relationship data includes a capacity time series and a voltage time series of the battery cell during charging or discharging of the battery cell.

10. A battery pack comprising the battery diagnosis apparatus according to any one of claims 1 to 9.

11. A battery system comprising the battery diagnosis apparatus according to any one of claims 1 to 9.

12. A battery diagnosis method comprising the steps of:

    acquiring capacity-voltage relationship data of a battery cell;
    generating a voltage profile and a differential voltage of the battery cell based on the capacity-voltage relationship data;
    extracting a first profile of interest from the voltage profile based on a feature point of the differential voltage profile;
    determining a characteristic curvature related to the first profile of interest; and
    diagnosing a degradation state of the battery cell based on the characteristic curvature.

13. The battery diagnosis method according to claim 12,
    wherein the step of extracting the first profile of interest from the voltage profile comprises the steps of:

    determining a capacity range of interest based on a capacity value of the feature point of the differential voltage profile; and
    determining a portion of the voltage profile corresponding to the capacity range of interest as the first profile of interest.

14. The battery diagnosis method according to claim 12,
    wherein the step of determining the characteristic curvature related to the first profile of interest comprises the steps of:

    determining a second profile of interest by normalizing a capacity-voltage domain of the first profile of interest to match it to a reference capacity-voltage domain; and
    determining the characteristic curvature based on a plurality of data points of the second profile of interest.

15. The battery diagnosis method according to claim 14,
    wherein the step of determining the characteristic curvature based on the plurality of data points of the second profile of interest comprises the steps of:

    determining a plurality of curvatures associated with a plurality of point sets respectively, wherein each point set includes three data points of the plurality of data points; and
    determining the characteristic curvature to be equal to a minimum of the plurality of curvatures or an average of two or more curvatures of the plurality of curvatures.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

```
        ( Start )
            │
            ▼
┌─────────────────────────────────┐
│  Acquire capacity-voltage        │ ~S1310
│  relationship data of battery cell│
└─────────────────────────────────┘
            │
            ▼
┌─────────────────────────────────┐
│  Generate voltage profile and    │ ~S1320
│  differential voltage profile of  │
│  battery                          │
└─────────────────────────────────┘
            │
            ▼
┌─────────────────────────────────┐
│  Extract first profile of interest│ ~S1330
│  from voltage profile based on    │
│  feature point of differential    │
│  voltage profile                  │
└─────────────────────────────────┘
            │
            ▼
┌─────────────────────────────────┐
│  Determine characteristic         │ ~S1340
│  curvature related to first       │
│  profile of interest              │
└─────────────────────────────────┘
            │
            ▼
┌─────────────────────────────────┐
│  Diagnose degradation state of    │ ~S1350
│  battery cell based on            │
│  characteristic curvature         │
└─────────────────────────────────┘
            │
            ▼
┌ ─ ─ ─ ─ ─ ─ ─ ─ ─ ─ ─ ─ ─ ─ ─ ─ ┐
│  Determine at least one protection │ ~S1360
│  parameter for battery cell        │
└ ─ ─ ─ ─ ─ ─ ─ ─ ─ ─ ─ ─ ─ ─ ─ ─ ┘
            │
            ▼
┌ ─ ─ ─ ─ ─ ─ ─ ─ ─ ─ ─ ─ ─ ─ ─ ─ ┐
│  Control charge/discharge of       │ ~S1370
│  battery cell based on at least    │
│  one protection parameter          │
└ ─ ─ ─ ─ ─ ─ ─ ─ ─ ─ ─ ─ ─ ─ ─ ─ ┘
            │
            ▼
         ( End )
```

FIG. 14

S1320                                    S1330

```
┌──────────────────────────────────────────────────┐
│   ┌───────────────────────────────────────┐        │
│   │  Determine feature point from differential │ ~S1410
│   │         voltage profile                │        │
│   └───────────────────────────────────────┘        │
│                                                    │
│   ┌───────────────────────────────────────┐        │
│   │  Determine capacity range of interest based on │ ~S1420
│   │       capacity value of feature point  │        │
│   └───────────────────────────────────────┘        │
│                                                    │
│   ┌───────────────────────────────────────┐        │
│   │  Determine part of voltage profile corresponding to │ ~S1430
│   │  capacity range of interest as first profile of interest │
│   └───────────────────────────────────────┘        │
└──────────────────────────────────────────────────┘
```

S1340

FIG. 15

S1320                                    S1410

Detect maximum point having maximum
differential voltage in target capacity range from
differential voltage profile       ~S1510

Determine minimum point located at higher
capacity side than maximum point as
feature point of differential voltage profile    ~S1520

S1420

FIG. 16

S1330          S1340

Determine second profile of interest by normalizing
capacity-voltage domain of first profile of interest     ~S1610

Determine characteristic curvature based on a
plurality of data points of second profile of interest     ~S1620

S1350

FIG. 17

```
                    ┌─────────────┐
                    │    Start    │
                    └─────────────┘
                          │                          S1620
    ┌ ─ ─ ─ ─ ─ ─ ─ ─ ─ ─ │ ─ ─ ─ ─ ─ ─ ─ ─ ─ ─ ─ ─ ┐
    ┌───────────────────────────────────────────┐
    │  Generate a plurality of point sets, each   │
    │  including three data points, from a        │─S1710
    │  plurality of data points                   │
    └───────────────────────────────────────────┘
                          │
    ┌───────────────────────────────────────────┐
    │  Determine a plurality of curvatures, each  │─S1720
    │  related to each of the plurality of point  │
    │  sets                                       │
    └───────────────────────────────────────────┘
                          │
    ┌───────────────────────────────────────────┐
    │  Determine characteristic curvature to be   │
    │  equal to minimum of the plurality of       │─S1730
    │  curvatures or average of two or more       │
    │  curvatures of the plurality of curvatures  │
    └───────────────────────────────────────────┘
    └ ─ ─ ─ ─ ─ ─ ─ ─ ─ ─ │ ─ ─ ─ ─ ─ ─ ─ ─ ─ ─ ─ ─ ┘
                          │
                    ┌─────────────┐
                    │     End     │
                    └─────────────┘
```

# EP 4 697 044 A1

<table>
<tr><th colspan="2">INTERNATIONAL SEARCH REPORT</th><th>International application No.</th></tr>
<tr><td colspan="2"></td><td>**PCT/KR2024/021438**</td></tr>
</table>

**A. CLASSIFICATION OF SUBJECT MATTER**

**G01R 31/392**(2019.01)i; **G01R 31/396**(2019.01)i; **G01R 31/382**(2019.01)i; **G01R 31/367**(2019.01)i; **G01R 19/30**(2006.01)i; **G01R 19/12**(2006.01)i

According to International Patent Classification (IPC) or to both national classification and IPC

**B. FIELDS SEARCHED**

Minimum documentation searched (classification system followed by classification symbols)

G01R 31/392(2019.01); B60L 58/10(2019.01); G01R 31/367(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 용량(capacity), 전압(voltage), 프로파일 (profile), 곡률(curvature)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2019-0118534 A (LG CHEM, LTD.) 18 October 2019 (2019-10-18)<br>See paragraphs [0066]-[0119], claims 13-14 and figures 2 and 4. | 1-4,7-14 |
| A | | 5-6,15 |
| Y | KR 10-2022-0159818 A (LG ENERGY SOLUTION, LTD.) 05 December 2022 (2022-12-05)<br>See paragraphs [0044] and [0095] and figure 2. | 1-4,7-14 |
| Y | KR 10-2022-0033350 A (LG ENERGY SOLUTION, LTD.) 16 March 2022 (2022-03-16)<br>See paragraph [0110] and figure 8. | 1-4,7-14 |
| A | KR 10-2021-0146699 A (LG ENERGY SOLUTION, LTD.) 06 December 2021 (2021-12-06)<br>See claims 1-11 and figures 1-5. | 1-15 |
| A | KR 10-2022-0094464 A (LG ENERGY SOLUTION, LTD.) 06 July 2022 (2022-07-06)<br>See claims 1-10 and figures 1-6. | 1-15 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **03 April 2025** | **03 April 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 697 044 A1

**INTERNATIONAL SEARCH REPORT**
Information on patent family members

International application No.

**PCT/KR2024/021438**

| Patent document cited in search report | | | Publication date (day/month/year) | Patent family member(s) | | | Publication date (day/month/year) |
|---|---|---|---|---|---|---|---|
| KR | 10-2019-0118534 | A | 18 October 2019 | CN | 111263894 | A | 09 June 2020 |
| | | | | CN | 111263894 | B | 13 May 2022 |
| | | | | EP | 3674730 | A1 | 01 July 2020 |
| | | | | EP | 3674730 | A4 | 16 September 2020 |
| | | | | EP | 3674730 | B1 | 07 April 2021 |
| | | | | JP | 2020-532267 | A | 05 November 2020 |
| | | | | JP | 6922144 | B2 | 18 August 2021 |
| | | | | KR | 10-2420091 | B1 | 12 July 2022 |
| | | | | PL | 3674730 | T3 | 16 August 2021 |
| | | | | US | 11391780 | B2 | 19 July 2022 |
| | | | | US | 2020-0408846 | A1 | 31 December 2020 |
| | | | | WO | 2019-199057 | A1 | 17 October 2019 |
| KR | 10-2022-0159818 | A | 05 December 2022 | CN | 116324452 | A | 23 June 2023 |
| | | | | EP | 4206707 | A1 | 05 July 2023 |
| | | | | EP | 4206707 | A4 | 17 April 2024 |
| | | | | EP | 4206707 | B1 | 12 February 2025 |
| | | | | JP | 2023-541181 | A | 28 September 2023 |
| | | | | JP | 7560229 | B2 | 02 October 2024 |
| | | | | US | 2024-0036116 | A1 | 01 February 2024 |
| | | | | WO | 2022-250390 | A1 | 01 December 2022 |
| KR | 10-2022-0033350 | A | 16 March 2022 | CN | 115917344 | A | 04 April 2023 |
| | | | | EP | 4155748 | A1 | 29 March 2023 |
| | | | | EP | 4155748 | A4 | 13 December 2023 |
| | | | | EP | 4155748 | B1 | 14 August 2024 |
| | | | | ES | 2991380 | T3 | 03 December 2024 |
| | | | | JP | 2023-515595 | A | 13 April 2023 |
| | | | | JP | 7362990 | B2 | 18 October 2023 |
| | | | | KR | 10-2652327 | B1 | 27 March 2024 |
| | | | | PL | 4155748 | T3 | 16 December 2024 |
| | | | | US | 2023-0280403 | A1 | 07 September 2023 |
| | | | | WO | 2022-055264 | A1 | 17 March 2022 |
| KR | 10-2021-0146699 | A | 06 December 2021 | CN | 114174845 | A | 11 March 2022 |
| | | | | CN | 114174845 | B | 09 April 2024 |
| | | | | EP | 4053573 | A1 | 07 September 2022 |
| | | | | EP | 4053573 | A4 | 07 June 2023 |
| | | | | JP | 2022-545940 | A | 01 November 2022 |
| | | | | JP | 7338101 | B2 | 05 September 2023 |
| | | | | US | 2023-0023014 | A1 | 26 January 2023 |
| | | | | WO | 2021-241886 | A1 | 02 December 2021 |
| KR | 10-2022-0094464 | A | 06 July 2022 | CN | 115943316 | A | 07 April 2023 |
| | | | | EP | 4166956 | A1 | 19 April 2023 |
| | | | | EP | 4166956 | A4 | 24 April 2024 |
| | | | | EP | 4166956 | B1 | 25 September 2024 |
| | | | | ES | 2989348 | T3 | 26 November 2024 |
| | | | | JP | 2023-527137 | A | 27 June 2023 |
| | | | | JP | 7459440 | B2 | 02 April 2024 |
| | | | | US | 2023-0273264 | A1 | 31 August 2023 |
| | | | | WO | 2022-145830 | A1 | 07 July 2022 |

Form PCT/ISA/210 (patent family annex) (July 2022)

**REFERENCES CITED IN THE DESCRIPTION**

**Patent documents cited in the description**

- KR 1020240000301